# EUROPEAN PATENT SPECIFICATION

(11) **EP 4 643 362 B1**
(45) Date of publication and mention of the grant of the patent: **21.10.2026**
(21) Application number: 24708022.9
(22) Date of filing: 19.01.2024
(51) Int. Cl.: H01H 9/54, H01H 33/59, H02H 3/08

(54) **DC SOLID-STATE CIRCUIT BREAKER WITH A SOLID-STATE AIDED AIRGAP THAT PROVIDES A FAIL-SAFE MECHANISM**
GLEICHSTROM-HALBLEITERSCHUTZSCHALTER MIT EINEM HALBLEITERUNTERSTÜTZTEN LUFTSPALT ZUR BEREITSTELLUNG EINES AUSFALLSICHEREN MECHANISMUS
DISJONCTEUR À SEMI-CONDUCTEURS CC POURVU D'UN ENTREFER ASSISTÉ À SEMI-CONDUCTEURS QUI FOURNIT UN MÉCANISME À SÉCURITÉ INTÉGRÉE

(30) Priority: 07.03.2023 US 202318179548
(43) Date of publication of application: 05.11.2025
(73) Proprietor: Siemens Industry, Inc., Alpharetta, Georgia 30005-4437 (US)
(72) Inventor: YANG, Guang, Johns Creek, Georgia 30097 (US)
(74) Representative: Isarpatent
(86) International application number: PCT/US2024/012086
(87) International publication number: WO 2024/186410

(56) References cited:
- EP-A1- 4 075 618
- EP-A1- 4 318 520
- WO-A1-2022/211273

## Description

### BACKGROUND

### 1. Field

Aspects of the present invention generally relate to a DC solid-state circuit breaker including a solid-state aided airgap to ensure successful interruption of current at DC conditions and provide a fail-safe mechanism in case of main power electronics failure.

### 2. Description of the Related Art

In today's electricity distribution, alternate current (AC) power stays vast majority as a form of supply. However, many electronic devices and end systems, such as an electric vehicle, home appliances and data centers use direct current (DC) power. Therefore, conversion between AC and DC is inevitable, and energy waste happens at the conversion point. A direct DC to DC supply is much more efficient. A fundamental issue of DC supply system is that existing protection devices, such as circuit breakers, are mainly designed for AC system and are not suitable for similar voltage DC system. For example, a 120V AC rated circuit breaker cannot be used in a 125V DC system, and can only be used with lower DC voltage, such as 48V. This is mainly due to the contacts used in today's thermal-magnetic circuit breakers create arcs, which cannot be effectively extinguished without the natural zero crossing in AC systems. For efficiency purposes, today's systems increasingly need higher DC voltages, such as 380V and 500V, which requires expensive and bulky mechanical designs, but still can suffer from reliability issues due to the inherent issue of lack of zero crossing. Therefore, a smaller, more cost effective, and more reliable DC circuit breaker design is needed.

Solid-state circuit breakers use power electronics as switching components instead of contacts as in traditional thermal-magnetic circuit breakers, and the switching process is arc free. Therefore, solid-state circuit breakers show promising aspects for use in both AC and DC systems. However, solid-state circuit breakers normally have an air gap in series of power electronic components for isolation purposes. For solid-state circuit breakers designed for AC systems, air gaps can be used as fail-safe mechanisms when power electronics fail in shorted conditions. In such situation, the arc can simply interrupt AC powers with the help of natural zero crossing. In DC systems, as discussed above, air gaps can no longer be used for such purposes, because the possibility of its own failure on interruption.

Therefore, there is a need for an improved system architecture for a DC solid-state circuit breaker.

WO 2022/211273 A1 discloses a semiconductor circuit breaker. The semiconductor circuit breaker comprises a switching device provided in an upper space; an air gap switch (mechanical switch) provided in the upper space and disposed forward of the switching device; an electric circuit disposed on an upper portion of the switching device; a heatsink provided in a lower space of the enclosure and coupled to a lower portion of the switching device; and a cooling fan provided in the lower space and disposed in a front portion.

EP 4 075 618 A1 discloses an isolation circuit for reversibly galvanically isolating a load from a DC voltage source, a switch box comprising at least one isolation circuit and a method for reversibly galvanically isolating the load from the DC voltage source by means of the isolation circuit.

### SUMMARY

Briefly described, aspects of the present invention relate to a solid-state circuit breaker for DC applications. In this invention, a system architecture for a DC solid-state circuit breaker is described. The DC solid-state circuit breaker uses a solid-state aided airgap to ensure successful interruption of current at DC conditions, and therefore provides an acceptable fail-safe mechanism in case of main power electronics failure. This DC solid-state circuit breaker realizes the full potential of solid-state technology in DC applications.

In accordance with one illustrative embodiment of the present invention, a DC solid-state circuit breaker is provided. It comprises a sensing and control circuit configured to realize designed functions. It further comprises a power electronics section that includes a first solid-state switching component for normal operations. It further comprises an air gap section disposed in series with the power electronics section and is configured to perform fail-safe interruption and to provide isolation. The air gap section includes an isolation switch which is connected in series to a fail-safe interruption combination of a current commutation switch and a second solid-state switching component, which are connected in parallel.

In accordance with one illustrative embodiment of the present invention, a method is provided for providing a fail-safe mechanism in a DC solid-state circuit breaker. The method comprises providing a sensing and control circuit configured to realize designed functions, providing a power electronics section that includes a first solid-state switching component for normal operations and providing an air gap section disposed in series with the power electronics section, and is configured to perform fail-safe interruption and to provide isolation. The air gap section includes an isolation switch which is connected in series to a fail-safe interruption combination of a current commutation switch and a second solid-state switching component, which are connected in parallel.

The above described features and advantages, as well as others, will become more readily apparent to those of ordinary skill in the art by reference to the following detailed description and accompanying drawings. While it would be desirable to provide one or more of these or other advantageous features, the teachings disclosed herein extend to those embodiments which fall within the scope of the appended claims, regardless of whether they accomplish one or more of the above-mentioned advantages.

### BRIEF DESCRIPTION OF THE DRAWINGS

For a more complete understanding of the present disclosure, and the advantages thereof, reference is now made to the following descriptions taken in conjunction with the accompanying drawings, wherein like numbers designate like objects.
FIG. 1 illustrates a DC solid-state circuit breaker in accordance with an exemplary embodiment of the present invention.
FIG. 2 illustrates a main current path of a DC solid-state circuit breaker in that if a Q1 fails being shorted, a current continues to flow as shown regardless of a turn-OFF signal to the Q1 in accordance with an exemplary embodiment of the present invention.
FIG. 3 illustrates a first sequencing method for the SW2, the Q2 and the RV3 in accordance with an exemplary embodiment of the present invention.
FIG. 4 illustrates a second sequencing method for the SW2, the Q2 and the RV3 in that the arcs between the SW2 contacts triggers a high voltage and turns on the Q2 in accordance with an exemplary embodiment of the present invention.
FIG. 5 illustrates a second sequencing method for the SW2, the Q2 and the RV3 in that a current is transferred from the SW2 to the Q2 after the Q2 is turned ON and a low voltage is observed, and it turns OFF the Q2 in accordance with an exemplary embodiment of the present invention.
FIG. 6 illustrates a method for providing a fail-safe mechanism in a DC solid-state circuit breaker in accordance with an exemplary embodiment of the present invention.

### DETAILED DESCRIPTION

Various technologies that pertain to systems and methods that facilitate a DC solid-state circuit breaker that can provide a fail-safe mechanism will now be described with reference to the drawings, where like reference numerals represent like elements throughout. The drawings discussed below, and the various embodiments used to describe the principles of the present disclosure in this patent document are by way of illustration only and should not be construed in any way to limit the scope of the disclosure. Those skilled in the art will understand that the principles of the present disclosure may be implemented in any suitably arranged apparatus. It is to be understood that functionality that is described as being carried out by certain system elements may be performed by multiple elements. Similarly, for instance, an element may be configured to perform functionality that is described as being carried out by multiple elements. The numerous innovative teachings of the present application will be described with reference to exemplary non-limiting embodiments.

To facilitate an understanding of embodiments, principles, and features of the present invention, they are explained hereinafter with reference to implementation in illustrative embodiments. In particular, they are described in the context of a DC solid-state circuit breaker that includes a solid-state aided airgap. Embodiments of the present invention, however, are not limited to use in the described devices or methods.

The components and materials described hereinafter as making up the various embodiments are intended to be illustrative and not restrictive. Many suitable components and materials that would perform the same or a similar function as the materials described herein are intended to be embraced within the scope of embodiments of the present invention.

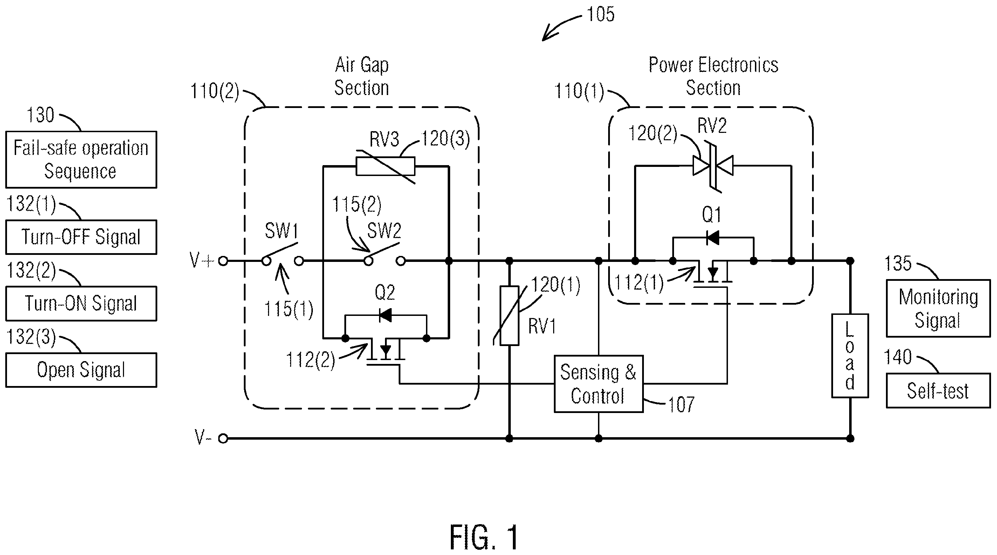

These and other embodiments of the DC solid-state circuit breaker according to the present disclosure are described below with reference to FIGs. 1-6 herein. Like reference numerals used in the drawings identify similar or identical elements throughout the several views. The drawings are not necessarily drawn to scale.

Consistent with one embodiment of the present invention, FIG. 1 represents a DC solid-state circuit breaker 105 in accordance with an exemplary embodiment of the present invention. The DC solid-state circuit breaker 105 comprises a sensing and control circuit 107 configured to realize designed functions. The DC solid-state circuit breaker 105 further comprises a power electronics section 110(1) that includes a first solid-state switching component Q1 112(1) for normal operations. The DC solid-state circuit breaker 105 further comprises an air gap section 110(2) disposed in series with the power electronics section 110(1), and is configured to perform fail-safe interruption and to provide isolation. The air gap section 110(2) includes an isolation switch SW1 115(1) which is connected in series to a fail-safe interruption combination of a current commutation switch SW2 115(2) and a second solid-state switching component Q2 112(2), which are connected in parallel.

The DC solid-state circuit breaker 105 further comprises a first overvoltage protection device RV1 120(1) and a second overvoltage protection device RV2 120(2) which is provided to protect the first solid-state switching component Q1 112(1) during an overvoltage after interruptions. The first solid-state switching component Q1 112(1) is semiconductor based, such as metal-oxide-semiconductor field-effect transistors (MOSFETs) and Thyristors.

The DC solid-state circuit breaker 105 further comprises a third overvoltage protection device RV3 120(3). Both the isolation switch SW1 115(1) and the current commutation switch SW2 115(2) need to open for a successful fail-safe interruption. The first solid-state switching component Q1 112(1) may be a single component or multiple components connected in parallel and the second overvoltage protection device RV2 120(2) may be connected in parallel to the first solid-state switching component Q1 112(1) or may be connected between a system voltage after the first solid-state switching component Q1 112(1).

In the DC solid-state circuit breaker 105, the second solid-state switching component Q2 112(2) may be a single component or multiple components connected in parallel and both the isolation switch SW1 115(1) and the current commutation switch SW2 115(2) may be triggered to turn OFF by the sensing and control circuit 107 through actuators, such as solenoids and electromagnets.

In the DC solid-state circuit breaker 105, the first overvoltage protection device RV1 120(1), the second overvoltage protection device RV2 120(2), the third overvoltage protection device RV3 120(3) may be a Metal Oxide Varistor (MOV), a transient-voltage-suppression (TVS) diode, and a snubber circuit etc.

In the DC solid-state circuit breaker 105, a fail-safe operation sequence 130 of a fail-safe mechanism is as following: under conditions with component failures, where the first solid-state switching component Q1 112(1) is not able to interrupt, the current commutation switch SW2 115(2) opens to allow current to pass through the second solid-state switching component Q2 112(2), which then can be switched OFF for interruption such that the isolation switch SW1 115(1) also opens to provide a galvanic isolation.

Two different methods can be used to sequence operations between components during interruption: for a first method, after a time delay of sending a turn-OFF signal 132(1) to the first solid-state switching component Q1 112(1), the sensing and control circuit 107 sends an open signal 132(3) to the current commutation switch SW2 115(2) and sends a turn-ON signal 132(2) to the second solid-state switching component Q2 112(2) with or without a time delay such that the second solid-state switching component Q2 112(2) is then turned ON to carry the load current, and the current commutation switch SW2 115(2) is opened by its actuator. The second solid-state switching component Q2 112(2) is then turned OFF after a time delay, which allows the current commutation switch SW2 115(2) to physically open enough to withstand an overvoltage without breaking down. However, if the overvoltage is higher than a threshold of the third overvoltage protection device RV3 120(3), then the third overvoltage protection device RV3 120(3) turns ON automatically to absorb energy.

For a second method, a monitoring signal 135, such as voltage or position across the current commutation switch SW2 115(2) is used to determine if the second solid-state switching component Q2 112(2) is turned ON, and remaining sequence follows from above the first method.

When the DC solid-state circuit breaker 105 is in a normal condition, an operating sequence can still be implemented but the difference is that the first solid-state switching component Q1 112(1) interrupts a current at the beginning of the operating sequence and the air gap section 110(2) opens without a load current.

To reclose a circuit the isolation switch SW1 115(1) and the current commutation switch SW2 115(2) are closed first then the sensing and control circuit 107 is configured to perform a self-test 140 and turn ON the first solid-state switching component Q1 112(1) if the self-test 140 is successful. In case of a failure such as the shorted first solid-state switching component Q1 112(1), the self-test 140 is unsuccessful, and the operating sequence for the air gap section 110(2) happens to interrupt the current again while in case of other failure like the shorted second solid-state switching component Q2 112(2), the first solid-state switching component Q1 112(1) doesn't turn ON and no load current is available.

FIG. 1 shows the diagram of a solid-state circuit breaker for DC application. There are two sections connected in series in the main current path, the power electronics section 110(1) for normal use interruption, and the airgap section 110(2) for fail-safe interruption and isolation. The sensing and control circuit 107 is also provided to control the main current path. The sensing control circuit 107 can be powered by the system voltage or can be powered by other means. The sensing and control circuit 107 is also protected by a surge protection component such as the RV1 120(1).

The power electronics section 110(1) consists of main power electronics modules, such as MOSFETs or Thyristors, e.g., the Q1 112(1), and the second overvoltage protection device, RV2 120(2). The RV2 120(2) is to protect the main power electronics modules during the overvoltage after fast interruptions. The Q1 112(1) can be a single components or multiple components connected in parallel. The RV2 120(2) can be connected in parallel to the main power electronics modules or can be connected between the system voltage after the main power electronics.

The air gap section 110(2) is in series to the power electronics section 110(1) and is designed to perform fail-safe interruption and to provide isolation. The air gap section 110(2) consists of the isolation switch SW1 115(1), which is connected in series to a fail-safe interruption combination. The fail-safe interruption combination has the current commutation switch SW2 115(2), connected in parallel to the second solid-state switching component Q2 112(2), and the third overvoltage protection device RV3 120(3). The isolation switch SW1 115(1) and the current commutation switch SW2 115(2) are configured in such a way that the current commutation switch SW2 115(2) always open before the isolation switch SW1 115(1).

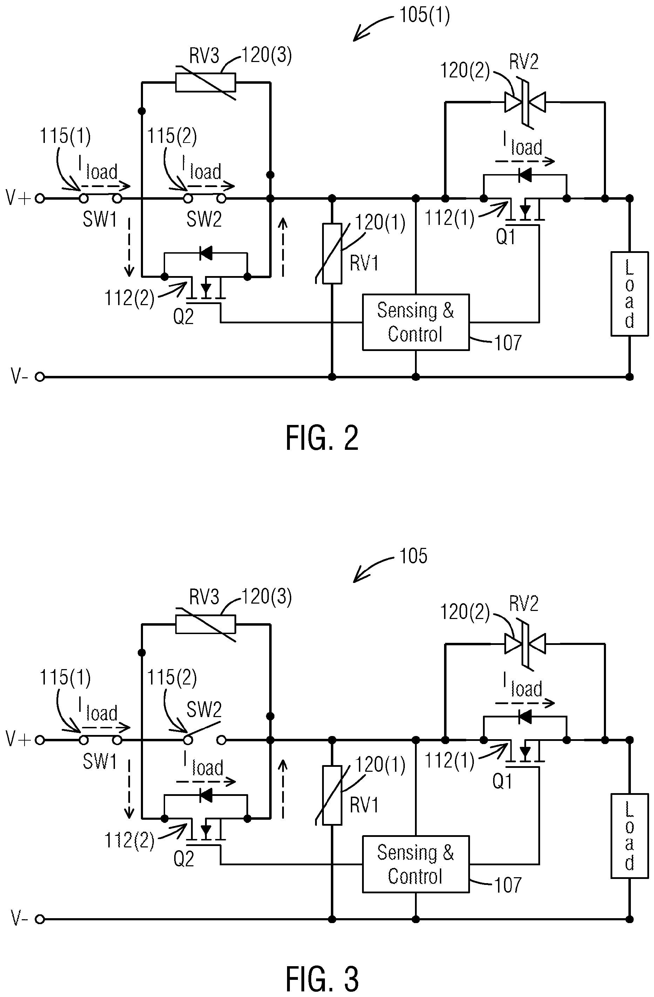

Referring to FIG. 2, it illustrates a main current path of a DC solid-state circuit breaker 105(1) in that if the Q1 112(1) fails being shorted, a current continues to flow as shown regardless of a turn-OFF signal to the Q1 112(1) in accordance with an exemplary embodiment of the present invention. A fail-safe operation sequence is as following. Under conditions with component failures, such as the Q1 112(1) is shorted, the sensing and control circuit 107 detects a fault condition or receive turn-OFF signals and sends a turn-OFF signal to the Q1 112(1). However, the Q1 112(1) is not able to interrupt, and a load current is still present, as shown in FIG. 2.

Turning now to FIG. 3, it illustrates a first sequencing method for the current commutation switch SW2 115(2), the second solid-state switching component Q2 112(2) and the third overvoltage protection device RV3 120(3) in accordance with an exemplary embodiment of the present invention. As stated before, mechanical switches, such as the isolation switch SW1 115(1) and the current commutation switch SW2 115(2), have challenges of interrupting the currents on their own, especially when the system voltage is high. Therefore, the combination of the current commutation switch SW2 115(2), the second solid-state switching component Q2 112(2) and the third overvoltage protection device RV3 120(3) is used to ensure successful interruption. In this case the second solid-state switching component Q2 112(2) becomes the main interruption component and is not affected by the lack of zero crossing. Two different methods can be used to sequence the operations between the components. For the first method, after a time delay, the sensing and control circuit 107 sends an open signal to the current commutation switch SW2 115(2) and sends a turn-ON signal to the second solid-state switching component Q2 112(2) with or without a time delay. The second solid-state switching component Q2 112(2) is then turned ON to carry the load current, and the current commutation switch SW2 115(2) is opened by its actuator. The second solid-state switching component Q2 112(2) is then turned OFF after a time delay, which allows the current commutation switch SW2 115(2) to physically open enough to withstand the overvoltage without breaking down, as shown in FIG. 3.

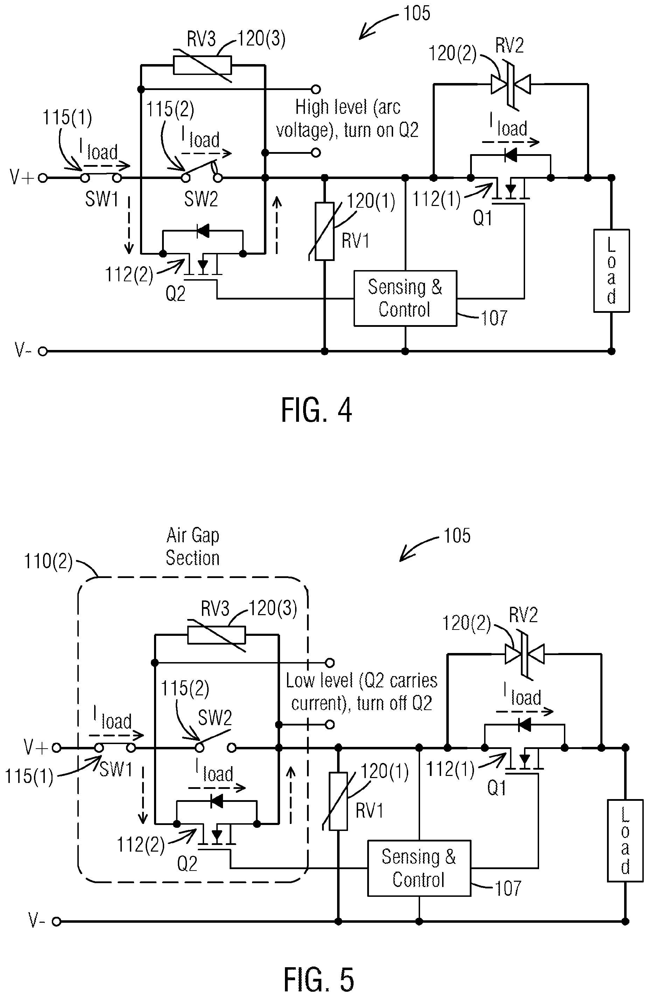

FIG. 4 illustrates a second sequencing method for the current commutation switch SW2 115(2), the second solid-state switching component Q2 112(2) and the third overvoltage protection device RV3 120(3) in that the arcs between the current commutation switch SW2 115(2) contacts triggers a high voltage and turns ON the second solid-state switching component Q2 112(2) in accordance with an exemplary embodiment of the present invention. If the overvoltage is higher than the threshold of the third overvoltage protection device RV3 120(3), the third overvoltage protection device RV3 120(3) turns ON automatically to absorb the energy. For this second method,
the advantage is that the current commutation switch SW2 115(2) doesn't need to open under current, so arcing is eliminated or minimized. The drawback is that the second solid-state switching component Q2 112(2) needs to stay ON with a load current for relatively long period, since it needs to stay ON before the current commutation switch SW2 115(2) opens and to stay ON after the current commutation switch SW2 115(2) opens wide enough to withstand overvoltage. With a large load current, the long ON-time of the second solid-state switching component Q2 112(2) means more expensive and sophisticated components. Therefore, this method is better suited for a smaller load current. For the second method, a voltage monitoring is added across the current commutation switch SW2 115(2), and the voltage across the current commutation switch SW2 115(2) is used to determine if the second solid-state switching component Q2 112(2) is turned ON. When the current commutation switch SW2 115(2) is opened by an actuator, an arc is drawn, and a voltage jump in the order of 10-20V is seen across the current commutation switch SW2 115(2). The higher voltage level can be used as the trigger to turn ON the second solid-state switching component Q2 112(2), and hence commute the current from the current commutation switch SW2 115(2) to the second solid-state switching component Q2 112(2), as shown in FIG. 4.

As seen in FIG. 5, it illustrates a second sequencing method for the current commutation switch SW2 115(2), the second solid-state switching component Q2 112(2) and the third overvoltage protection device RV3 120(3) in that a current is transferred from the current commutation switch SW2 115(2) to the second solid-state switching component Q2 112(2) after the second solid-state switching component Q2 112(2) is turned ON and a low voltage is observed, and it turns OFF the second solid-state switching component Q2 112(2) in accordance with an exemplary embodiment of the present invention.

After current is transferred to the second solid-state switching component Q2 112(2), the on-state voltage drop of the second solid-state switching component Q2 112(2) is normally much smaller, in the order of 3-4V. This lower voltage level can be used as the trigger to turn OFF the second solid-state switching component Q2 112(2), and the current is interrupted, as shown in FIG. 5. The advantage of this second method is that the second solid-state switching component Q2 112(2) is only turned ON when necessary, therefore doesn't require expensive components. The drawbacks are arcs between the current commutation switch SW2 115(2) contacts, and the second solid-state switching component Q2 112(2) may have to be turned ON and OFF more than once until the current commutation switch SW2 115(2) is opened wide enough to withstand overvoltage. After the load current is interrupted by the combination of the current commutation switch SW2 115(2), the second solid-state switching component Q2 112(2) and the third overvoltage protection device RV3 120(3), the isolation switch SW1 115(1) is then opened for isolation, as shown in FIG. 1.

When the DC solid-state circuit breaker 105 is in a normal condition, the operating sequence above can still be implemented. The difference is that the first solid-state switching component Q1 112(1) interrupts the current at the beginning of the operating sequence, and the air gap section 110(2) opens without a load current.

To reclose the circuit, the isolation switch SW1 115(1) and the current commutation switch SW2 115(2) are closed first, no particular order needed. Then, the sensing and control circuit 107 performs a self-test and turns ON the first solid-state switching component Q1 112(1) if the self-test is successful. In case of failure like the shorted first solid-state switching component Q1 112(1), the self-test is unsuccessful, and the operation sequence for the air gap section 110(2) as described above happens to interrupt the current again. In case of other failure like the shorted second solid-state switching component Q2 112(2), the first solid-state switching component Q1 112(1) doesn't turn ON and no load current is available.

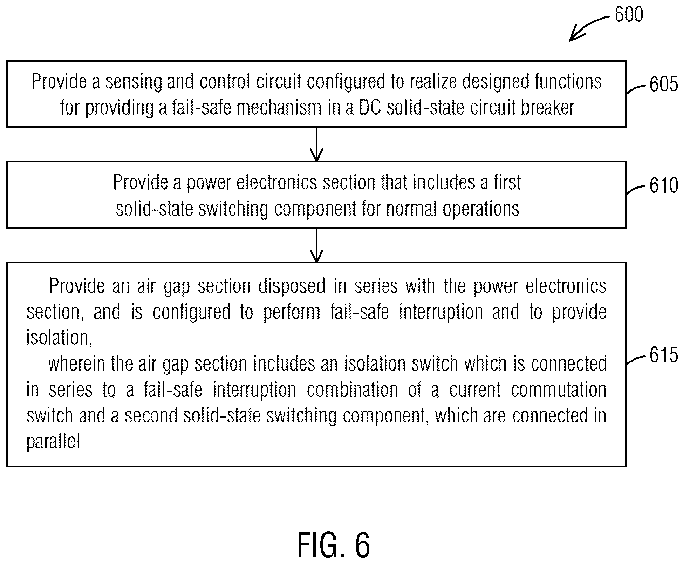

As shown in FIG. 6, it illustrates a method 600 for providing a fail-safe mechanism in the DC solid-state circuit breaker 105 in accordance with an exemplary embodiment of the present invention. Reference is made to the elements and features described in FIGs. 1-5. It should be appreciated that some steps are not required to be performed in any particular order, and that some steps may be optional.

The method 600 comprises a step 605 of providing the sensing and control circuit 107 configured to realize designed functions. The method 600 further comprises a step 610 of providing the power electronics section 110(1) that includes a first solid-state switching component Q1 for normal operations. The method 600 further comprises a step 615 of providing the air gap section 110(2) disposed in series with the power electronics section 110(1) and is configured to perform fail-safe interruption and to provide isolation. The air gap section 110(2) includes the isolation switch SW1 which is connected in series to a fail-safe interruption combination of the current commutation switch SW2 and the second solid-state switching component Q2, which are connected in parallel.

A semiconductor material-based design of the first solid-state switching component such as metal-oxide-semiconductor field-effect transistors (MOSFETs) and Thyristors is described in the claims.

The techniques described herein can be particularly useful for a smaller, more cost effective, and more reliable DC circuit breaker design that uses a solid-state aided airgap to ensure successful interruption of current at DC conditions. While particular embodiments are described in terms of this arrangement, the techniques described herein are not limited to such an arrangement but can also be used with other arrangements.

## Claims

1. A DC solid-state circuit breaker (105) comprising:
a sensing and control circuit (107) configured to realize designed functions;
a power electronics section (110(1)) that includes a first solid-state switching component (112(1)) for normal operations; and
an air gap section (110(2)) disposed in series with the power electronics section (110(1)), and is configured to perform fail-safe interruption and to provide isolation, and
wherein the air gap section (110(2)) includes an isolation switch (115(1)) which is connected in series to a fail-safe interruption combination of a current commutation switch (115(2)) and a second solid-state switching component (112(2)), which are connected in parallel.

2. The DC solid-state circuit breaker of claim 1, further comprising:
a first overvoltage protection device (120(1)); and
a second overvoltage protection device (120(2)) which is provided to protect the first solid-state switching component (112(1)) during an overvoltage after interruptions, and
wherein the first solid-state switching component (112(1)) is semiconductor based, such as metal-oxide-semiconductor field-effect transistors -MOSFETs- and thyristors; and
a third overvoltage protection device (120(3)), wherein both the isolation switch 115(1) and the current commutation switch (115(2)) need to open for a successful fail-safe interruption, and
wherein the first solid-state switching component (112(1)) may be a single component or multiple components connected in parallel and the second overvoltage protection device (120(2)) may be connected in parallel to the first solid-state switching component (112(1)) or may be connected between a system voltage after the first solid-state switching component (112(1)).

3. The DC solid-state circuit breaker of claim 2, wherein the second solid-state switching component (112(2)) may be a single component or multiple components connected in parallel and both the isolation switch (115(1)) and the current commutation switch (115(2)) may be triggered to turn OFF by the sensing and control circuit (107) through actuators, such as solenoids and electromagnets.

4. The DC solid-state circuit breaker of claim 2, wherein the first overvoltage protection device (120(1)), the second overvoltage protection device (120(2)), the third overvoltage protection device (120(3)) may be a Metal Oxide Varistor -MOV-, a transient-voltage-suppression -TVS- diode, and a snubber circuit.

5. The DC solid-state circuit breaker of claim 2, wherein a fail-safe operation sequence (130) of a fail-safe mechanism is as following: under conditions with component failures, where the first solid-state switching component (112(1)) is not able to interrupt, the current commutation switch (115(2)) opens to allow current to pass through the second solid-state switching component (112(2)), which then can be switched OFF for interruption, wherein the isolation switch (115(1)) also opens to provide a galvanic isolation.

6. The DC solid-state circuit breaker of claim 5, wherein for a first method of sequencing operations between components during interruption, after a time delay of sending a turn-OFF signal (132(1)) to the first solid-state switching component (112(1)), the sensing and control circuit (107) sends an open signal to the current commutation switch (115(2)) and sends a turn-ON signal (132(2)) to the second solid-state switching component (112(2)) with or without a time delay such that the second solid-state switching component (112(2)) is then turned ON to carry the load current, and the current commutation switch (115(2)) is opened by its actuator,
wherein the second solid-state switching component (112(2)) is then turned OFF after a time delay, which allows the current commutation switch (115(2)) to physically open enough to withstand an overvoltage without breaking down,
wherein if the overvoltage is higher than a threshold of the third overvoltage protection device (120(3)), then the third overvoltage protection device (120(3)) turns ON automatically to absorb energy.

7. The DC solid-state circuit breaker of claim 6, wherein for a second method, a monitoring signal (135), such as voltage or position across the current commutation switch (115(2)) is used to determine if the second solid-state switching component (112(2)) is turned ON, and the remaining sequence follows from the first method defined in claim 6.

8. The DC solid-state circuit breaker of claim 7, wherein when the DC solid-state circuit breaker (105) is in a normal condition, an operating sequence can still be implemented but the difference is that the first solid-state switching component (112(1)) interrupts a current at the beginning of the operating sequence and the air gap section (110(2)) opens without a load current.

9. The DC solid-state circuit breaker of claim 8, wherein to reclose a circuit the isolation switch (115(1)) and the current commutation switch (115(2)) are closed first then the sensing and control circuit (107) is configured to perform a self-test (140) and turn ON the first solid-state switching component (112(1)) if the self-test (140) is successful,
in particular wherein in case of a failure such as the shorted first solid-state switching component (112(1)), the self-test (140) is unsuccessful, and the operating sequence for the air gap section (110(2)) happens to interrupt the current again while in case of other failure like the shorted second solid-state switching component (112(2)), the first solid-state switching component (112(1)) doesn't turn ON and no load current is available.

10. A method for providing a fail-safe mechanism in a DC solid-state circuit breaker, the method comprising:
providing a sensing and control circuit (107) configured to realize designed functions;
providing a power electronics section (110(1)) that includes a first solid-state switching component (112(1)) for normal operations; and
providing an air gap section (110(2)) disposed in series with the power electronics section (110(1)), and is configured to perform fail-safe interruption and to provide isolation, and
wherein the air gap section (110(2)) includes an isolation switch (115(1)) which is connected in series to a fail-safe interruption combination of a current commutation switch (115(2)) and a second solid-state switching component (112(2)), which are connected in parallel.

11. The method of claim 10, further comprising:
providing a first overvoltage protection device (120(1)); and
providing a second overvoltage protection device (120(2)) which is provided to protect the first solid-state switching component (112(1)) during an overvoltage after interruptions, and
wherein the first solid-state switching component (112(1)) is semiconductor based, such as metal-oxide-semiconductor field-effect transistors -MOSFETs- and thyristors; and
providing a third overvoltage protection device (120(3)), wherein both the isolation switch 115(1) and the current commutation switch (115(2)) need to open for a successful fail-safe interruption, and
wherein the first solid-state switching component (112(1)) may be a single component or multiple components connected in parallel and the second overvoltage protection device (120(2)) may be connected in parallel to the first solid-state switching component (112(1)) or may be connected between a system voltage after the first solid-state switching component (112(1)).

12. The method of claim 11,
wherein the second solid-state switching component (112(2)) may be a single component or multiple components connected in parallel and both the isolation switch (115(1)) and the current commutation switch (115(2)) may be triggered to turn OFF by the sensing and control circuit (107) through actuators, such as solenoids and electromagnets; or
wherein the first overvoltage protection device (120(1)), the second overvoltage protection device (120(2)), the third overvoltage protection device (120(3)) may be a Metal Oxide Varistor -MOV-, a transient-voltage-suppression -TVS- diode, and a snubber circuit; or
wherein a fail-safe operation sequence (130) of a fail-safe mechanism is as following: under conditions with component failures, where the first solid-state switching component (112(1)) is not able to interrupt, the current commutation switch (115(2)) opens to allow current to pass through the second solid-state switching component (112(2)), which then can be switched OFF for interruption, wherein the isolation switch 115(1) also opens to provide a galvanic isolation.

13. The method of claim 12, wherein two different methods can be used to sequence operations between components during interruption: for a first method, after a time delay of sending a turn-OFF signal (132(1)) to the first solid-state switching component (112(1)), the sensing and control circuit (107) sends an open signal to the current commutation switch (115(2)) and sends a turn-ON signal (132(2)) to the second solid-state switching component (112(2)) with or without a time delay such that the second solid-state switching component (112(2)) is then turned ON to carry the load current, and the current commutation switch (115(2)) is opened by its actuator,
wherein the second solid-state switching component (112(2)) is then turned OFF after a time delay, which allows the current commutation switch (115(2)) to physically open enough to withstand an overvoltage without breaking down,
wherein if the overvoltage is higher than a threshold of the third overvoltage protection device (120(3)), then the third overvoltage protection device (120(3)) turns ON automatically to absorb energy,
in particular wherein for a second method, a monitoring signal (135), such as voltage or position across the current commutation switch (115(2)) is used to determine if the second solid-state switching component (112(2)) is turned ON, and the remaining sequence is carried out as defined above.

14. The method of claim 13, wherein when the DC solid-state circuit breaker (105) is in a normal condition, an operating sequence can still be implemented but the difference is that the first solid-state switching component (112(1)) interrupts a current at the beginning of the operating sequence and the air gap section (110(2)) opens without a load current.

15. The method of claim 14, wherein to reclose a circuit the isolation switch (115(1)) and the current commutation switch (115(2)) are closed first then the sensing and control circuit (107) is configured to perform a self-test (140) and turn ON the first solid-state switching component (112(1)) if the self-test (140) is successful , in particular wherein in case of a failure such as the shorted first solid-state switching component (112(1)), the self-test (140) is unsuccessful, and the operating sequence for the air gap section (110(2)) happens to interrupt the current again while in case of other failure like the shorted second solid-state switching component (112(2)), the first solid-state switching component (112(1)) doesn't turn ON and no load current is available.

## Patentansprüche

1. DC-Halbleiterschutzschalter (105), umfassend:
eine Erfassungs- und Steuerschaltung (107), die konfiguriert ist, um konzipierte Funktionen zu realisieren;
einen Leistungselektronikabschnitt (110(1)), der eine erste Halbleiterschaltkomponente (112(1)) für normale Operationen beinhaltet; und
einen Luftspaltabschnitt (110(2)), der in einer Reihe mit dem Leistungselektronikabschnitt (110(1)) angeordnet ist und konfiguriert ist, um eine ausfallsichere Unterbrechung durchzuführen und um eine Isolierung bereitzustellen, und
wobei der Luftspaltabschnitt (110(2)) einen Isolationsschalter (115(1)) beinhaltet, der mit einer ausfallsicheren Unterbrechungskombination eines Stromkommutierungsschalters (115(2)) und einer zweiten Halbleiterschaltkomponente (112(2)) in Reihe geschaltet ist, die ihrerseits parallel geschaltet sind.

2. DC-Halbleiterschutzschalter nach Anspruch 1, der ferner umfasst:
eine erste Überspannungsschutzvorrichtung (120(1)); und
eine zweite Überspannungsschutzvorrichtung (120(2)), die bereitgestellt wird, um die erste Halbleiterschaltkomponente (112(1)) während einer Überspannung nach Unterbrechungen zu schützen, und
wobei die erste Halbleiterschaltkomponente (112(1)) halbleiterbasiert ist, wie zum Beispiel Metalloxid-Halbleiter-Feldeffekttransistoren -MOSFETs- und Thyristoren; und
eine dritte Überspannungsschutzvorrichtung (120(3)), wobei sowohl der Isolationsschalter 115(1) als auch der Stromkommutierungsschalter (115(2)) für eine erfolgreiche ausfallsichere Unterbrechung geöffnet werden müssen, und
wobei die erste Halbleiterschaltkomponente (112(1)) aus einer einzigen Komponente oder mehreren Komponenten bestehen kann, die parallel geschaltet sind, und wobei die zweite Überspannungsschutzvorrichtung (120(2)) zu der ersten Halbleiterschaltkomponente (112(1)) parallel geschaltet werden kann oder in eine Systemspannung hinter der ersten Halbleiterschaltkomponente (112(1)) geschaltet sein kann.

3. DC-Halbleiterschutzschalter nach Anspruch 2, wobei die zweite Halbleiterschaltkomponente (112(2)) aus einer einzigen Komponente oder mehreren Komponenten bestehen kann, die parallel geschaltet sind, und wobei sowohl der Isolationsschalter (115(1)) als auch der Stromkommutierungsschalter (115(2)) ausgelöst werden können, um von der Erfassungs- und Steuerschaltung (107) durch Stellglieder, wie zum Beispiele Magnetventile und Elektromagnete, ausgeschaltet zu werden.

4. DC-Halbleiterschutzschalter nach Anspruch 2, wobei die erste Überspannungsschutzvorrichtung (120(1)), die zweite Überspannungsschutzvorrichtung (120(2)), die dritte Überspannungsschutzvorrichtung (120(3)) ein Metalloxid-Varistor -MOV-, eine Transientenspannungsunterdrückungsdiode -TVS-Diode- und eine Snubber-Schaltung sein können.

5. DC-Halbleiterschutzschalter nach Anspruch 2, wobei eine ausfallsichere Operationssequenz (130) eines ausfallsicheren Mechanismus wie folgt abläuft: unter Bedingungen mit Komponentenausfällen, bei denen die erste Halbleiterschaltkomponente (112(1)) nicht zum Unterbrechen in der Lage ist, öffnet sich der Stromkommutierungsschalter (115(2)), um zu erlauben, dass Strom durch die zweite Halbleiterschaltkomponente (112(2)) fließt, die dann für eine Unterbrechung ausgeschaltet werden kann, wobei sich der Isolationsschalter (115(1)) ebenfalls öffnet, um eine galvanische Isolierung bereitzustellen.

6. DC-Halbleiterschutzschalter nach Anspruch 5, wobei für ein erstes Verfahren zum Sequenzieren von Operationen zwischen Komponenten während einer Unterbrechung nach einer Zeitverzögerung des Sendens eines Ausschaltsignals (132(1)) an die erste Halbleiterschaltkomponente (112(1)), die Erfassungs- und Steuerschaltung (107) ein Öffnungssignal an den Stromkommutierungsschalter (115(2)) sendet und ein Einschaltsignal (132(2)) mit oder ohne Zeitverzögerung an die zweite Halbleiterschaltkomponente (112(2)) sendet, sodass die zweite Halbleiterschaltkomponente (112(2)) danach eingeschaltet wird, um den Laststrom zu tragen, und der Stromkommutierungsschalter (115(2)) von seinem Stellglied geöffnet wird,
wobei die zweite Halbleiterschaltkomponente (112(2)) dann nach einer Zeitverzögerung ausgeschaltet wird, die es dem Stromkommutierungsschalter (115(2)) erlaubt, sich physisch ausreichend zu öffnen, um, ohne auszufallen, einer Überspannung standzuhalten,
wobei, wenn die Überspannung höher als ein Schwellenwert der dritten Überspannungsschutzvorrichtung (120(3)) ist, die dritte Überspannungsschutzvorrichtung (120(3)) automatisch eingeschaltet wird, um Energie zu absorbieren.

7. DC-Halbleiterschutzschalter nach Anspruch 6, wobei für ein zweites Verfahren ein Überwachungssignal (135), wie zum Beispiel eine Spannung oder eine Position über dem Stromkommutierungsschalter (115(2)), verwendet wird, um zu ermitteln, ob die zweite Halbleiterschaltkomponente (112(2)) eingeschaltet ist, und wobei sich die verbleibende Sequenz aus dem ersten Verfahren ergibt, das in Anspruch 6 definiert wird.

8. DC-Halbleiterschutzschalter nach Anspruch 7, wobei, wenn sich der DC-Halbleiterschutzschalter (105) in einem normalen Zustand befindet, noch immer eine Operationssequenz implementiert werden kann, aber der Unterschied ist, dass die erste Halbleiterschaltkomponente (112(1)) einen Strom am Beginn der Operationssequenz unterbricht und der Luftspaltabschnitt (110(2)) ohne einen Laststrom öffnet.

9. DC-Halbleiterschutzschalter nach Anspruch 8, wobei zum erneuten Verschließen einer Schaltung der Isolationsschalter (115(1)) und der Stromkommutierungsschalter (115(2)) zuerst geschlossen werden, und die Erfassungs- und Steuerschaltung (107) danach konfiguriert wird, um einen Selbsttest (140) durchzuführen und um die erste Halbleiterschaltkomponente (112(1)) einzuschalten, wenn der Selbsttest (140) erfolgreich ist,
wobei insbesondere im Fall eines Ausfalls, wie zum Beispiel bei der kurzgeschlossenen ersten Halbleiterschaltkomponente (112(1)), der Selbsttest (140) erfolglos ist und die Operationssequenz für den Luftspaltabschnitt (110(2)) zufällig den Strom erneut unterbricht, während im Fall eines anderen Ausfalls, wie zum Beispiel bei der kurzgeschlossenen zweiten Halbleiterschaltkomponente (112(2)), die erste Halbleiterschaltkomponente (112(1)) nicht eingeschaltet wird und kein Laststrom zur Verfügung steht.

10. Verfahren zum Bereitstellen eines ausfallsicheren Mechanismus in einem DC-Halbleiterschutzschalter, wobei das Verfahren umfasst:
Bereitstellen einer Erfassungs- und Steuerschaltung (107), die konfiguriert ist, um konzipierte Funktionen zu realisieren;
Bereitstellen eines Leistungselektronikabschnitts (110(1)), der eine erste Halbleiterschaltkomponente (112(1)) für normale Operationen beinhaltet; und
Bereitstellen eines Luftspaltabschnitts (110(2)), der in einer Reihe mit dem Leistungselektronikabschnitt (110(1)) angeordnet ist und konfiguriert ist, um eine ausfallsichere Unterbrechung durchzuführen und um eine Isolierung bereitzustellen, und
wobei der Luftspaltabschnitt (110(2)) einen Isolationsschalter (115(1)) beinhaltet, der mit einer ausfallsicheren Unterbrechungskombination eines Stromkommutierungsschalters (115(2)) und einer zweiten Halbleiterschaltkomponente (112(2)) in Reihe geschaltet ist, die ihrerseits parallel geschaltet sind.

11. Verfahren nach Anspruch 10, das ferner umfasst:
Bereitstellen einer ersten Überspannungsschutzvorrichtung (120(1)); und
Bereitstellen einer zweiten Überspannungsschutzvorrichtung (120(2)), die bereitgestellt wird, um die erste Halbleiterschaltkomponente (112(1)) während einer Überspannung nach Unterbrechungen zu schützen, und
wobei die erste Halbleiterschaltkomponente (112(1)) halbleiterbasiert ist, wie zum Beispiel Metalloxid-Halbleiter-Feldeffekttransistoren -MOSFETs- und Thyristoren; und
Bereitstellen einer dritten Überspannungsschutzvorrichtung (120(3)), wobei sowohl der Isolationsschalter 115(1) als auch der Stromkommutierungsschalter (115(2)) für eine erfolgreiche ausfallsichere Unterbrechung geöffnet werden müssen, und
wobei die erste Halbleiterschaltkomponente (112(1)) aus einer einzigen Komponente oder mehreren Komponenten bestehen kann, die parallel geschaltet sind, und wobei die zweite Überspannungsschutzvorrichtung (120(2)) zu der ersten Halbleiterschaltkomponente (112(1)) parallel geschaltet werden kann oder in eine Systemspannung hinter der ersten Halbleiterschaltkomponente (112(1)) geschaltet sein kann.

12. Verfahren nach Anspruch 11,
wobei die zweite Halbleiterschaltkomponente (112(2)) aus einer einzigen Komponente oder mehreren Komponenten bestehen kann, die parallel geschaltet sind, und wobei sowohl der Isolationsschalter (115(1)) als auch der Stromkommutierungsschalter (115(2)) ausgelöst werden können, um von der Erfassungs- und Steuerschaltung (107) durch Stellglieder, wie zum Beispiele Magnetventile und Elektromagnete, ausgeschaltet zu werden.
wobei die erste Überspannungsschutzvorrichtung (120(1)), die zweite Überspannungsschutzvorrichtung (120(2)), die dritte Überspannungsschutzvorrichtung (120(3)) ein Metalloxid-Varistor -MOV-, eine Transientenspannungsunterdrückungsdiode -TVS-Diode- und eine Snubber-Schaltung sein können.
wobei eine ausfallsichere Operationssequenz (130) eines ausfallsicheren Mechanismus wie folgt abläuft: unter Bedingungen mit Komponentenausfällen, bei denen die erste Halbleiterschaltkomponente (112(1)) nicht zum Unterbrechen in der Lage ist, öffnet sich der Stromkommutierungsschalter (115(2)), um zu erlauben, dass Strom durch die zweite Halbleiterschaltkomponente (112(2)) fließt, die dann für eine Unterbrechung ausgeschaltet werden kann, wobei sich der Isolationsschalter (115(1)) ebenfalls öffnet, um eine galvanische Isolierung bereitzustellen.

13. Verfahren nach Anspruch 12, wobei zwei unterschiedliche Verfahren zum Sequenzieren von Operationen zwischen Komponenten während einer Unterbrechung verwendet werden können: wobei, für ein erstes Verfahren zum Sequenzieren von Operationen zwischen Komponenten während einer Unterbrechung nach einer Zeitverzögerung eines Sendens eines Ausschaltsignals (132(1)) an die erste Halbleiterschaltkomponente (112(1)), die Erfassungs- und Steuerschaltung (107) ein Öffnungssignal an den Stromkommutierungsschalter (115(2)) sendet und ein Einschaltsignal (132(2)) mit oder ohne Zeitverzögerung an die zweite Halbleiterschaltkomponente (112(2)) sendet, sodass die zweite Halbleiterschaltkomponente (112(2)) danach eingeschaltet wird, um den Laststrom zu tragen, und der Stromkommutierungsschalter (115(2)) von seinem Stellglied geöffnet wird,
wobei die zweite Halbleiterschaltkomponente (112(2)) dann nach einer Zeitverzögerung ausgeschaltet wird, die es dem Stromkommutierungsschalter (115(2)) erlaubt, sich physisch ausreichend zu öffnen, um, ohne auszufallen, einer Überspannung standzuhalten,
wobei, wenn die Überspannung höher als ein Schwellenwert der dritten Überspannungsschutzvorrichtung (120(3)) ist, die dritte Überspannungsschutzvorrichtung (120(3)) automatisch eingeschaltet wird, um Energie zu absorbieren,
wobei für ein zweites Verfahren insbesondere ein Überwachungssignal (135), wie zum Beispiel eine Spannung oder eine Position über dem Stromkommutierungsschalter (115(2)), verwendet wird, um zu ermitteln, ob die zweite Halbleiterschaltkomponente (112(2)) eingeschaltet ist, und wobei die verbleibende Sequenz ausgeführt wird, wie es weiter oben definiert wurde.

14. Verfahren nach Anspruch 13, wobei, wenn sich der DC-Halbleiterschutzschalter (105) in einem normalen Zustand befindet, noch immer eine Operationssequenz implementiert werden kann, aber der Unterschied ist, dass die erste Halbleiterschaltkomponente (112(1)) einen Strom am Beginn der Operationssequenz unterbricht und der Luftspaltabschnitt (110(2)) ohne einen Laststrom öffnet.

15. Verfahren nach Anspruch 14, wobei zum erneuten Verschließen einer Schaltung der Isolationsschalter (115(1)) und der Stromkommutierungsschalter (115(2)) zuerst geschlossen werden und die Erfassungs- und Steuerschaltung (107) danach konfiguriert wird, um einen Selbsttest (140) durchzuführen und um die erste Halbleiterschaltkomponente (112(1)) einzuschalten, wenn der Selbsttest (140) erfolgreich ist, wobei insbesondere im Fall eines Ausfalls, wie zum Beispiel bei der kurzgeschlossenen ersten Halbleiterschaltkomponente (112(1)), der Selbsttest (140) erfolglos ist und die Operationssequenz für den Luftspaltabschnitt (110(2)) zufällig den Strom erneut unterbricht, während im Fall eines anderen Ausfalls, wie zum Beispiel bei der kurzgeschlossenen zweiten Halbleiterschaltkomponente (112(2)), die erste Halbleiterschaltkomponente (112(1)) nicht eingeschaltet wird und kein Laststrom zur Verfügung steht.

## Revendications

1. Disjoncteur à semi-conducteurs CC (105) comprenant :
un circuit de détection et de commande (107) configuré pour réaliser des fonctions élaborées ;
une section d'électronique de puissance (110(1)) qui inclut un premier composant de commutation à semi-conducteurs (112(1)) pour un fonctionnement normal ; et
une section d'entrefer (110(2)) disposée en série avec la section d'électronique de puissance (110(1)), et configurée pour effectuer une interruption de sécurité et pour assurer une isolation, et
où la section d'entrefer (110(2)) comprend un commutateur d'isolement (115(1)) qui est connecté en série à une combinaison d'interruption à sécurité intégrée d'un commutateur de courant (115(2)) et d'un deuxième composant de commutation à semi-conducteurs (112(2)), qui sont connectés en parallèle.

2. Disjoncteur à semi-conducteurs CC selon la revendication 1, comprenant en outre :
un premier dispositif de protection contre les surtensions (120(1)) ; et
un deuxième dispositif de protection contre les surtensions (120(2)) est pourvu pour protéger le premier composant de commutation à semi-conducteurs (112(1)) pendant une surtension après des interruptions, et
où le premier composant de commutation à semi-conducteurs (112(1)) est à base de semi-conducteurs, tel que des transistors à effet de champ à semi-conducteurs métal-oxyde, MOSFET, et des thyristors ; et
un troisième dispositif de protection contre les surtensions (120(3)), dans lequel le commutateur d'isolement (115(1)) et le commutateur de commutation de courant (115(2)) doivent tous deux s'ouvrir pour une interruption réussie à sécurité intégrée, et
où le premier composant de commutation à semi-conducteurs (112(1)) peut être un composant unique ou plusieurs composants connectés en parallèle et le deuxième dispositif de protection contre les surtensions (120(2)) peut être connecté en parallèle au premier composant de commutation à semi-conducteurs (112(1)) ou peut être connecté entre une tension système après le premier composant de commutation à semi-conducteurs (112(1)).

3. Disjoncteur à semi-conducteurs CC selon la revendication 2, dans lequel le deuxième composant de commutation à semi-conducteurs (112(2)) peut être un composant unique ou plusieurs composants connectés en parallèle, et à la fois le commutateur d'isolement (115(1)) et le commutateur de commutation de courant (115(2)) peuvent être déclenchés pour se mettre hors conduction par le circuit de détection et de commande (107) par l'intermédiaire d'actionneurs, tels que des solénoïdes et des électroaimants.

4. Disjoncteur à semi-conducteurs CC selon la revendication 2, dans lequel le premier dispositif de protection contre les surtensions (120(1)), le deuxième dispositif de protection contre les surtensions (120(2)), le troisième dispositif de protection contre les surtensions (120(3)) peuvent être une varistance à oxyde métallique, MOV, une diode de suppression de tension transitoire, TVS, et un circuit d'amortissement.

5. Disjoncteur à semi-conducteurs CC selon la revendication 2, dans lequel une séquence de fonctionnement à sécurité intégrée (130) d'un mécanisme à sécurité intégrée est la suivante : en cas de défaillance de composant, où le premier composant de commutation à semi-conducteurs (112(1)) n'est pas capable de créer une interruption, le commutateur de commutation de courant (115(2)) s'ouvre pour permettre au courant de passer à travers le deuxième composant de commutation à semi-conducteurs (112(2)), qui peut ensuite être placé hors conduction pour une interruption, où le commutateur d'isolement (115(1)) s'ouvre également pour assurer un isolement galvanique.

6. Disjoncteur à semi-conducteurs CC selon la revendication 5, dans lequel, pour un premier procédé de séquencement des opérations entre des composants pendant l'interruption, après un délai d'envoi d'un signal de mise hors conduction (132(1)) au premier composant de commutation à semi-conducteurs (112(1)), le circuit de détection et de commande (107) envoie un signal de mise en conduction au commutateur de courant (115(2)) et envoie un signal de mise en conduction (132(2)) au deuxième composant de commutation à semi-conducteurs (112(2)) avec ou sans délai de telle sorte que le deuxième composant de commutation à semi-conducteurs (112(2)) soit ensuite mis en conduction pour transporter le courant de charge, et le commutateur de commutation de courant (115(2)) est ouvert par son actionneur, où le deuxième composant de commutation à semi-conducteurs (112(2)) est alors mis hors conduction après un délai, ce qui permet au commutateur de commutation de courant (115(2)) de s'ouvrir physiquement suffisamment pour supporter une surtension sans tomber en panne,
où, si la surtension est supérieure à un seuil du troisième dispositif de protection contre les surtensions (120(3)), alors le troisième dispositif de protection contre les surtensions (120(3)) passe automatiquement en conduction pour absorber l'énergie.

7. Disjoncteur à semi-conducteurs CC selon la revendication 6, dans lequel, pour un deuxième procédé, un signal de surveillance (135), tel qu'une tension ou une position aux bornes du commutateur de commutation de courant (115(2)), est utilisée pour déterminer si le deuxième composant de commutation à semi-conducteurs (112(2)) est passant, et la séquence restante suit le premier procédé défini dans la revendication 6.

8. Disjoncteur à semi-conducteurs CC selon la revendication 7, dans lequel, lorsque le disjoncteur à semi-conducteur CC (105) est dans un état normal, une séquence de fonctionnement peut encore être mise en œuvre, mais la différence est que le premier composant de commutation à semi-conducteurs (112(1)) interrompt un courant au début de la séquence de fonctionnement et que la section d'entrefer (110(2)) s'ouvre sans courant de charge.

9. Disjoncteur à semi-conducteurs CC selon la revendication 8, dans lequel, pour refermer un circuit, le commutateur d'isolement (115(1)) et le commutateur de commutation de courant (115(2)) sont d'abord fermés, puis le circuit de détection et de commande (107) est configuré pour effectuer un auto-test (140) et mettre en conduction le premier composant de commutation à semi-conducteurs (112(1)) si l'auto-test (140) est réussi,
en particulier, dans le cas d'une défaillance telle qu'un court-circuit du premier composant de commutation à semi-conducteurs (112(1)), l'auto-test (140) échoue, et la séquence de fonctionnement de la section d'entrefer (110(2)) arrive à interrompre à nouveau le courant, tandis qu'en cas de défaillance autre qu'un court-circuit du deuxième composant de commutation à semi-conducteurs (112(2)), le premier composant de commutation à semi-conducteurs (112(1)) ne passe pas à l'état passant et aucun courant de charge n'est disponible.

10. Procédé pour fournir un mécanisme à sécurité intégrée dans un disjoncteur à semi-conducteurs CC, le procédé comprenant les étapes suivantes :
fournir un circuit de détection et de commande (107) configuré pour réaliser des fonctions élaborées ;
fournir une section d'électronique de puissance (110(1)) qui inclut un premier composant de commutation à semi-conducteurs (112(1)) pour un fonctionnement normal ; et
fournir une section d'entrefer (110(2)) disposée en série avec la section d'électronique de puissance (110(1)), et configurée pour effectuer une interruption de sécurité et pour assurer une isolation, et
où la section d'entrefer (110(2)) comprend un commutateur d'isolement (115(1)) qui est connecté en série à une combinaison d'interruption à sécurité intégrée d'un commutateur de courant (115(2)) et d'un deuxième composant de commutation à semi-conducteurs (112(2)), qui sont connectés en parallèle.

11. Procédé selon la revendication 10, comprenant en outre les étapes suivantes :
fournir un premier dispositif de protection contre les surtensions (120(1)) ; et
fournir un deuxième dispositif de protection contre les surtensions (120(2)) est pourvu pour protéger le premier composant de commutation à semi-conducteurs (112(1)) pendant une surtension après des interruptions, et
où le premier composant de commutation à semi-conducteurs (112(1)) est à base de semi-conducteurs, tel que des transistors à effet de champ à semi-conducteurs métal-oxyde, MOSFET, et des thyristors ; et
fournir un troisième dispositif de protection contre les surtensions (120(3)), dans lequel le commutateur d'isolement (115(1)) et le commutateur de commutation de courant (115(2)) doivent tous deux s'ouvrir pour une interruption réussie à sécurité intégrée, et
où le premier composant de commutation à semi-conducteurs (112(1)) peut être un composant unique ou plusieurs composants connectés en parallèle et le deuxième dispositif de protection contre les surtensions (120(2)) peut être connecté en parallèle au premier composant de commutation à semi-conducteurs (112(1)) ou peut être connecté entre une tension système après le premier composant de commutation à semi-conducteurs (112(1)).

12. Procédé selon la revendication 11,
dans lequel le deuxième composant de commutation à semi-conducteurs (112(2)) peut être un composant unique ou plusieurs composants connectés en parallèle, et à la fois le commutateur d'isolement (115(1)) et le commutateur de commutation de courant (115(2)) peuvent être déclenchés pour se mettre hors conduction par le circuit de détection et de commande (107) par l'intermédiaire d'actionneurs, tels que des solénoïdes et des électroaimants ; ou
dans lequel le premier dispositif de protection contre les surtensions (120(1)), le deuxième dispositif de protection contre les surtensions (120(2)), le troisième dispositif de protection contre les surtensions (120(3)) peuvent être une varistance à oxyde métallique, MOV, une diode de suppression de tension transitoire, TVS, et un circuit d'amortissement ; ou
dans lequel une séquence de fonctionnement à sécurité intégrée (130) d'un mécanisme à sécurité intégrée est la suivante : en cas de défaillance de composant, où le premier composant de commutation à semi-conducteurs (112(1)) n'est pas capable de créer une interruption, le commutateur de commutation de courant (115(2)) s'ouvre pour permettre au courant de passer à travers le deuxième composant de commutation à semi-conducteurs (112(2)), qui peut ensuite être placé hors conduction pour une interruption, où le commutateur d'isolement (115(1)) s'ouvre également pour assurer un isolement galvanique.

13. Procédé selon la revendication 12, dans lequel deux procédés différents peuvent être utilisés pour séquencer des opérations entre des composants pendant une interruption : pour un premier procédé, après un délai d'envoi d'un signal de mise hors conduction (132(1)) au premier composant de commutation à semi-conducteurs (112(1)), le circuit de détection et de commande (107) envoie un signal de mise en conduction au commutateur de courant (115(2)) et envoie un signal de mise en conduction (132(2)) au deuxième composant de commutation à semi-conducteurs (112(2)) avec ou sans délai de telle sorte que le deuxième composant de commutation à semi-conducteurs (112(2)) soit ensuite mis en conduction pour transporter le courant de charge, et le commutateur de commutation de courant (115(2)) est ouvert par son actionneur,
où le deuxième composant de commutation à semi-conducteurs (112(2)) est alors mis hors conduction après un délai, ce qui permet au commutateur de commutation de courant (115(2)) de s'ouvrir physiquement suffisamment pour supporter une surtension sans tomber en panne,
où, si la surtension est supérieure à un seuil du troisième dispositif de protection contre les surtensions (120(3)), alors le troisième dispositif de protection contre les surtensions (120(3)) passe automatiquement en conduction pour absorber l'énergie,
en particulier, où, pour un deuxième procédé, un signal de surveillance (135), tel qu'une tension ou une position aux bornes du commutateur de courant (115(2)), est utilisée pour déterminer si le deuxième composant de commutation à semi-conducteurs (112(2)) est passant, et la séquence restante est exécutée comme défini ci-dessus.

14. Procédé selon la revendication 13, dans lequel, lorsque le disjoncteur à semi-conducteur CC (105) est dans un état normal, une séquence de fonctionnement peut encore être mise en œuvre, mais la différence est que le premier composant de commutation à semi-conducteurs (112(1)) interrompt un courant au début de la séquence de fonctionnement et que la section d'entrefer (110(2)) s'ouvre sans courant de charge.

15. Procédé selon la revendication 14, dans lequel, pour refermer un circuit, le commutateur d'isolement (115(1)) et le commutateur de commutation de courant (115(2)) sont d'abord fermés, puis le circuit de détection et de commande (107) est configuré pour effectuer un auto-test (140) et mettre en conduction le premier composant de commutation à semi-conducteurs (112(1)) si l'auto-test (140) est réussi, où, en particulier, en cas de défaillance telle qu'un court-circuit du premier composant de commutation à semi-conducteurs (112(1)), l'auto-test (140) échoue, et la séquence de fonctionnement de la section d'entrefer (110(2)) arrive à interrompre à nouveau le courant, tandis qu'en cas de défaillance autre qu'un court-circuit du deuxième composant de commutation à semi-conducteurs (112(2)), le premier composant de commutation à semi-conducteurs (112(1)) ne passe pas à l'état passant et aucun courant de charge n'est disponible.
